# EUROPEAN PATENT SPECIFICATION

(11) **EP 1 376 683 B1**
(45) Date of publication and mention of the grant of the patent: **07.03.2007**
(21) Application number: 02425428.6
(22) Date of filing: 28.06.2002
(51) Int. Cl.: H01L 21/762

(54) **Process for forming trenches with oblique profile and rounded top corners**
Herstellungsverfahren für Gräben mit schrägem Profil und gerundeten Oberkanten
Méthode de formation de tranches avec profil oblique et coins arrondies dans leur partie supérieure

(43) Date of publication of application: 02.01.2004
(73) Proprietor: STMicroelectronics S.r.l., 20041 Agrate Brianza (Milano) (IT)
(72) Inventor: Ciovacco, Francesco, 20159 Milano (IT); Savardi, Chiara, 25128 Brescia (IT); Colombo, Roberto, 20030 Lentate sul Seveso (IT)
(74) Representative: Cerbaro, Elena

(56) References cited:
- EP-A- 0 819 786
- US-A- 4 729 815
- US-A- 5 807 789
- US-A1- 2001 005 615
- PATENT ABSTRACTS OF JAPAN vol. 018, no. 020 (E-1489), 13 January 1994 (1994-01-13) -& JP 05 259269 A (SHARP CORP), 8 October 1993 (1993-10-08)

## Description

The present invention relates to a process for forming trenches with oblique profile and rounded top corners.

As is known, in microelectronics there is an ever increasing need to reduce the overall dimensions of integrated circuits. Clearly, to achieve this aim, it is necessary, on the one hand, to optimize the number of electronic components to be made and, on the other, to minimize the size of the components and, in general, of all the structures that cooperate in the operation of the integrated circuit.

The reduction of the size causes, however, difficulties, for example, in forming insulating structures that separate adjacent active areas, and it is therefore necessary to adopt particular solutions.

For example, so-called shallow-trench isolation (STI) structures are compatible with the use of technologies that enable the fabrication of active devices of length smaller than 0.25 µm. To form the insulating structures, in a wafer of semiconductor material a trench of preset width and depth is initially opened; then, the trench is filled with silicon oxide or with another dielectric material. The trench is normally dug by dry plasma etching, which is markedly anisotropic. The walls of the trench can in some cases be vertical, but frequently the geometrical and electrical characteristics of the circuits require the trench to have an oblique profile and the walls to be inclined, for example by an angle of between 65° and 85° («tapered trench»). This solution makes it possible, for example, to prevent the electric field lines from crowding near over-pronounced corners, so creating potentially dangerous situations.

In order to improve the insulating structures of an STI type, it has been proposed to provide the trenches with rounded top corners, using the top-corner rounding (TCR) technique. This technique chiefly provides two advantages: first, the space available for forming active areas increases and, second, the likelihood of the subsequent processing steps causing crystallographic defects is reduced.

A first known process for forming trenches provided with rounded top corners will be illustrated with reference to Figures 1-6. According to this process, a semiconductor wafer 1 is initially coated with a pad oxide layer 2 and with an stop layer 3 of silicon nitride having openings 4 obtained with conventional lithographic techniques (Figure 1). The stop layer 3 is to be used for subsequent steps of planarization of the wafer 1. Then, a thick oxide layer 5 is deposited so as to coat the stop layer 3 (Figure 2) and is then defined so as to form spacers 6 inside the openings 4 (Figure 3). In greater detail, the spacers 6 occupy peripheral portions of the openings 4, leaving central portions uncovered. By anisotropic plasma etching, a trench 7 with a preset profile is then opened (Figure 4) and, with a wet etch, the spacers 6 and portions of the pad oxide layer 2 inside the openings 4 are then removed (Figure 5). Now, the trench 7 is upwardly delimited by top corners 8 having edges 9. By a further dry etch, the edges 9 are tapered, so as to obtain rounded top corners 8'.

The described process is not, however, free from limitations. First, the dry etch for rounding off the edges 9 inevitably also involves the walls of the trench 7, the profile of which is modified in an uncontrollable way. This undesired effect is disadvantageous, since the electrical properties of an insulating structure depend, in general, also upon its shape. Clearly, it is difficult, if not impossible, to foresee accurately the electrical interactions between the insulating structure obtainable by filling in the trench 7 and the devices that are to be made in the wafer 1. These interactions can render the behavior of the devices integrated in the wafer significantly different from the design, both as regards performance and as regards safety margins for protection from any possible failure. In addition, numerous processing steps are necessary, in particular, a greater number of alternate plasma and wet etching steps. Consequently, the method is costly and complex to be implemented, and the risk of generating crystallographic defects is not satisfactorily small. Instead, on account of the high number and of the type of operations to be performed, the wafer must be handled and displaced a number of times between different machines: the wafer thus remains exposed to dust and other impurities that can cause defects or damage of varying degree.

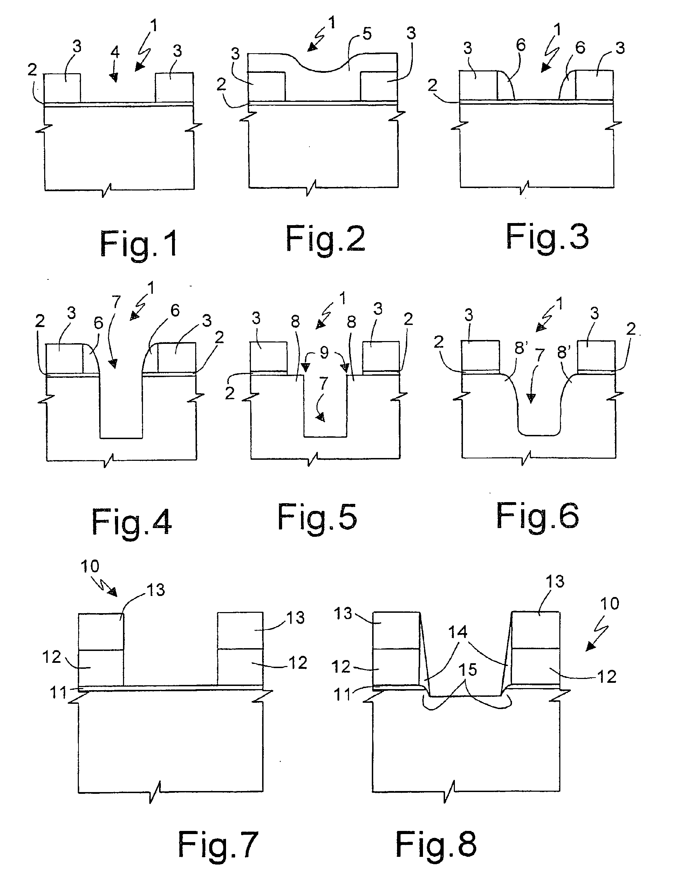

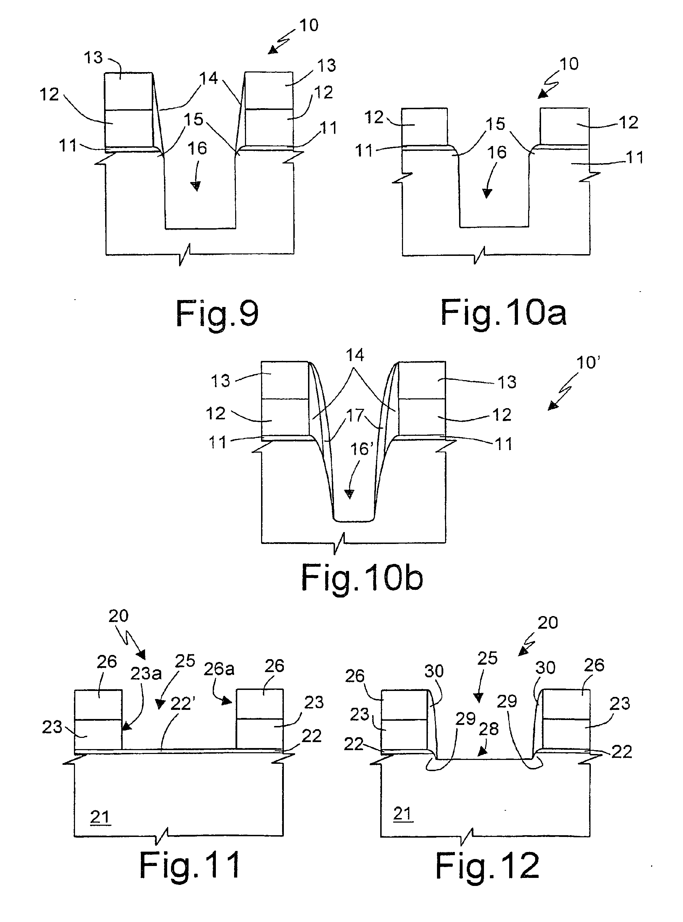

A different process, illustrated with reference to Figures 7-10, provides forming a pad oxide layer 11 and a stop layer 12 on top of a wafer 10, as already described. In particular, the stop layer 12 is defined using a resist mask 13. Then (Figure 8), uncovered portions of the pad oxide layer 11 and portions of silicon immediately underneath are removed through an anisotropic etch with inclined profile, in particular a polymerizing dry etch. As is known, this type of etching is performed in particular conditions, whereby, simultaneously with removing material from the wafer 1, the compounds present in the plasma are microdeposited. On the vertical or markedly inclined walls, the rate of microdeposition is higher than the rate of etching and consequently a protective polymeric film 14 progressively grows around the portions with high constant slope. Starting from the periphery, the horizontal surface exposed to etching gradually reduces over time; in this way, rounded top corners 15 are obtained, as shown in Figure 8. Finally, a trench 16 is opened through a further dry anisotropic etch (Figure 9), and the resist mask 13 and the polymeric film 14 are removed (Figure 10a).

The process described above, however, has a considerable limitation, in so far as it does not enable trenches with an oblique profile to be formed, but only ones with vertical profile. To obtain an oblique profile, in fact, it is necessary to perform a further polymerizing dry etch, using a polymer that is very different from the previous one. In addition, the trench is opened before removing the polymeric film formed during the first dry etch, which is thus still present. In practice, the polymeric film affects the evolution of the second dry etch, inducing different rates of polymerization according to the depth reached inside the wafer 10. In greater detail, during the second dry etch a second polymeric film 17 is formed, which, however, does not grow in a regular way: at the start of the process and in the proximity of the polymeric film 14, the growth of the second polymeric film 17 is more rapid and slows down as the trench 16' is dug. In practice, then, a crowned, substantially cusp-shaped, profile is obtained, as shown in Figure 10b. The cusp-shaped profile is not satisfactory, both because it requires the devices to be designed taking into account complex phenomena, due precisely to the constant non-constant slope of the walls of the trench 16', and, above all, because it causes various problems in the subsequent processing steps. In particular, the filling of the trench 16' is problematical and thus is frequently imperfect; in the thermal treatment, the portions of the wafer 10' surrounding the trench 16' are subjected to extremely strong mechanical stresses; in addition, crystallographic defects may be formed, especially on the bottom of the trench 16'.

Alternatively, it is possible to remove the polymeric film 14 formed during the first polymerizing etch before performing the second etch. However, the complete removal of the film grown during a polymerizing etch is problematical and requires a wet washing of the wafer, which, however, causes complete removal of the residual resist. The subsequent etches would thus have a very limited polymerizing power (the polymer comes, in fact, to a great extent from the products of etching of the photoresist), preventing in practice the obtainment of the desired oblique profile. In addition, this solution involves picking up the wafer, setting it in a different machine, carrying out washing, and re-positioning of the wafer to carry out the second plasma etch. All these steps must evidently be repeated to remove the films 14 and 17 separately, thus rendering the fabrication process excessively complex.

EP 819786 discloses etching trenches with an oblique profile.

Examples of processes using polymerizing etches to form trenches with top rounded corners are described in US 2001/005615 A1 and US-A-5 807 789.

The aim of the present invention is to provide a process for forming insulating structures that is free from the drawbacks described above.

According to the present invention a process is provided for forming insulating structures with tapered profile and rounded top corners, as defined in claim 1.

For a better understanding of the invention, some embodiments thereof are now described, purely by way of non-limiting examples and with reference to the attached drawings, wherein:
- Figures 1-6 are cross-sections through a semiconductor wafer in successive processing steps, according to a known process;
- Figures 7-10b are cross-sections through semiconductor wafers in successive processing steps, according to a different known process;
- Figures 11-15 are cross-sections through a semiconductor wafer in successive processing steps of the process according to the present invention;

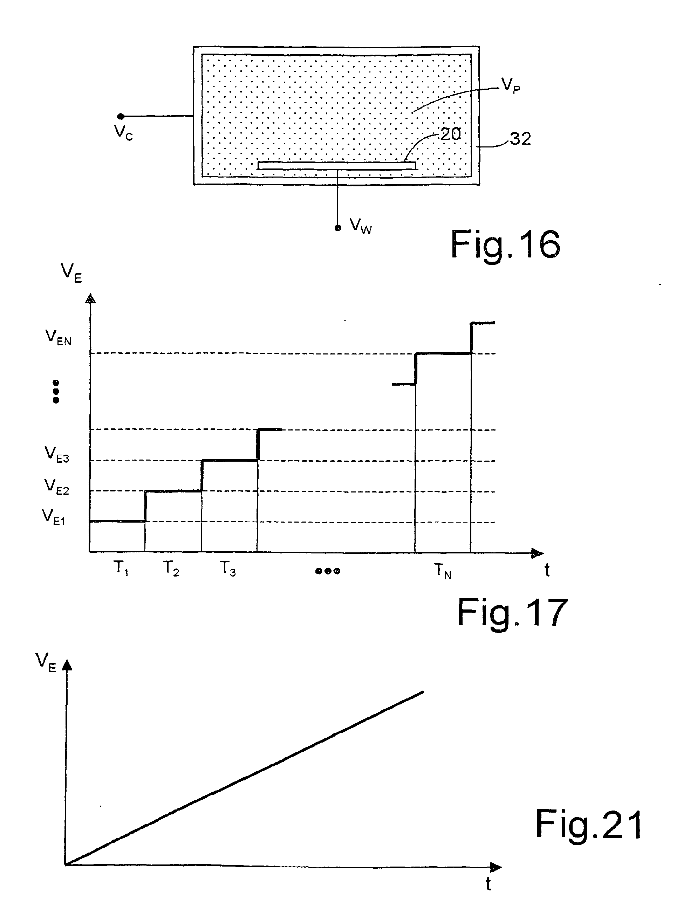

- Figure 16 is a schematic view of an apparatus used in one step of the process according to the present invention;
- Figure 17 is the plot of a quantity regarding the present process;
- Figures 18-20 are cross-sections of the wafer of Figures 11-15, in subsequent processing steps; and
- Figures 21-23 are plots of quantities regarding, respectively, a second, a third, and a fourth embodiment of the process according to the present invention.

With reference to Figures 11-20, a wafer 20 of semiconductor material, for example monocrystalline silicon, comprises a substrate 21, on which a pad oxide layer 22 is initially grown. On top of the pad oxide layer 22 a stop layer 23 is then formed, which is to be used for subsequent planarization of the wafer 20. The stop layer 23 has openings 25 uncovering portions 22' of the pad oxide layer 22; in particular the portions 22' rise above regions of the substrate 21 that are subsequently to be etched. The stop layer 23 is formed using a resist mask 26, which is deposited and then defined photolithographically.

Then, a first dry polymerizing etch is carried out, as shown in Figure 12. The polymerizing etch is a plasma etch, preferably a CHF₃- or CH₂F₂-based etch. In detail, in this step, the portions 22' of the pad oxide layer 22 are removed, and the underlying silicon is slightly dug so as to form depressions 28. During the polymerizing etch, on the surface 23a of the hard mask 23 and on the surface 26a of the resist mask 26 delimiting the openings 25 a first polymeric film 30 is formed, which gradually grows in thickness towards the inside of the openings 25. As the thickness of the first polymerizing film 30 increases, the exposed surface of the pad oxide layer 22 first and that of the substrate 21 next decreases, starting from the periphery. Consequently, with the passage of time the etch involves an increasingly restricted central area, which is dug more deeply at the bottom than at the peripheral areas. In this way, rounded top corners 29 are formed, which delimit the depressions 28.

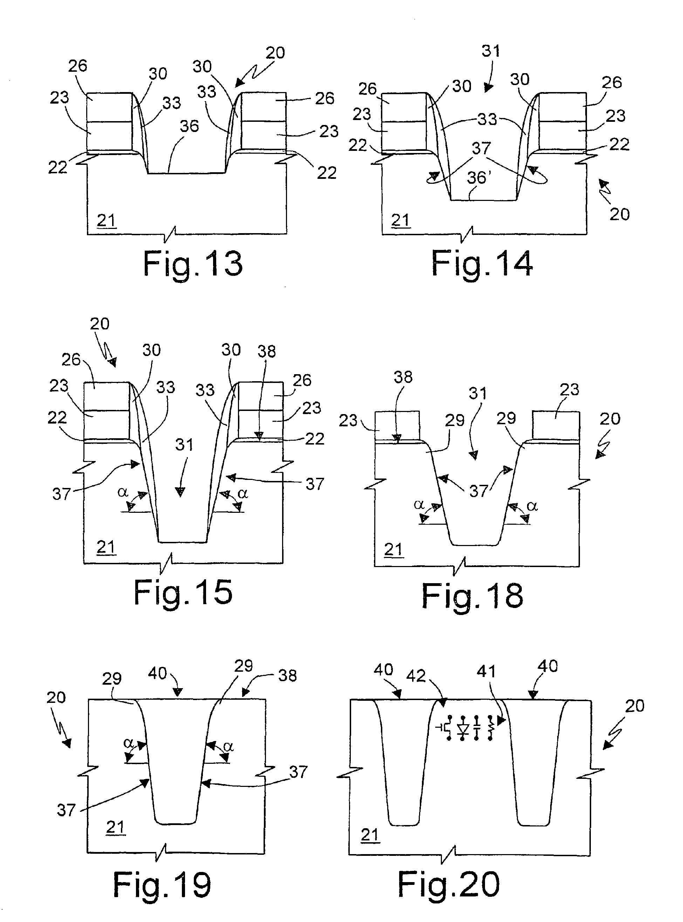

A second dry polymerizing etch is then performed to open a trench 31 (Figures 13-15). The second polymerizing etch is a markedly anisotropic plasma etch, preferably HBr- and O₂-based; in addition, the etch can be made in presence of Cl₂ and N₂. The second polymerizing etch is performed in variable plasma conditions. In greater detail, plasma etching is performed by placing the wafer 20 in an etching chamber 32, in which a known mixture of gases flows in predetermined conditions of temperature, pressure and flow (Figure 16). In addition, the etching chamber 32 is set at a chamber voltage V_{C}, while the wafer 20 is kept at a wafer voltage V_{W}. The plasma, coming into contact with the etching chamber 32, reaches a plasma voltage Vₚ higher by a known amount than the chamber voltage V_{c}. Consequently, an etching voltage V_{E} = V_{P} - V_{W} is present between the exposed surface of the wafer 20 (more specifically, of the substrate 21) and the plasma; in addition, the etching voltage V_{E} is controllable through the wafer voltage V_{W}. The rate of removal of the silicon and the rate of microdeposition of the polymeric material of the plasma are affected by various parameters, among which the etching voltage V_{E}. In particular, all other conditions being equal, the rate of microdeposition increases as the absolute value of the etching voltage V_{E} increases. Then, during the second polymerizing etch, a second polymeric film 33 is formed, which grows at a rate that depends upon the etching voltage V_{E}. According to the invention, the etching voltage V_{E} is varied during the second polymerizing etch so as to control the growth of the second polymeric film 33 and thus the slope of the walls 37 of the trench 31. In greater detail, the second polymerizing etch is performed in discrete steps and comprises a number N of steps performed in succession. As shown in Figure 17, associated to the etching steps are respective durations T₁, T₂, ..., T_{N} and respective increasing values V_{E1}, V_{E2}, ..., V_{EN} of the etching voltage V_{E}. For example, the second polymerizing etch can comprise three steps, each having a duration of 30 s. Furthermore, for each step the value of the etching voltage V_{E} is obtained by keeping the chamber voltage V_{C} constant (for example at 0 V) and imposing values of the wafer voltage V_{W} of 10 V, 20 V and 30 V, respectively. Thereby, a discrete-ramp etching voltage V_{E} is supplied. The etching steps are moreover performed one after the other, in rapid succession, substantially without interruptions.

In this way, the variations in the growth rate of the second polymerizing film 33 caused by the presence of the first polymerizing film 30 are compensated, in particular near the exposed surface 36 of the substrate 21. In an initial step of the second polymerizing etch (Figure 13), the growth of the second polymeric film is rapid because, in addition to the effect due to the etching voltage V_{E}, the presence of the first polymeric film 30 has a significant effect. In fact, the first polymeric film 30 is initially contiguous to the exposed surface 36 that is etched.

In a subsequent step (Figure 14), after a first amount of silicon has been removed and the trench 31 has started to form, the exposed surface 36' is found at a greater depth in the substrate 21. Given that the distance from the first polymeric film 30 has increased, the influence of the latter on the rate of growth of the second polymeric film 33 near the exposed surface 36' is smaller, but is compensated for by the increment imposed on the etching voltage V_{E}. In practice, then, the portion of the substrate 21 exposed to etching continues to decrease gradually and in a way correlated to the removal rate of the silicon; the slope of the walls 37 that delimit the trench 31 is thus kept constant.

In the subsequent etching steps, the etching voltage V_{E} is varied as already explained with reference to Figure 17, so that the variations in the microdeposition rate of polymeric material and in the removal rate of silicon will make up for the different effect caused by the first polymeric film 30.

Figure 15 shows the wafer 20 at the end of the second polymerizing etch: it is possible to identify the trench 31, delimited by the walls 37 with a constant slope α and the first and the second polymeric films 30, 33. In particular, the walls 37 constantly form an angle with respect to a surface parallel to a face 38 of the substrate 21. Preferably, the angle α is between 65° and 85° and, for example, is 80°.

After the second polymerizing etch, the first and the second polymeric films 30, 33 and the resist mask 26 are removed simultaneously with a single step of wet washing (Figure 18). By chemical-vapor deposition (CVD), the trench 31 is then completely filled with a dielectric material, preferably silicon oxide, so as to form an insulating structure 40 extending in the substrate 21 for the entire depth of the trench 31 (Figure 19). Excess portions of silicon oxide, the stop layer 23, and the pad oxide layer 22 are then removed after planarization of the wafer 20. The processing of the wafer 20 is then completed with standard steps for forming integrated circuits 41, represented schematically in Figure 20 by the symbols of active and passive electronic components. In particular, the integrated circuits 41 are made inside active areas 42 of the wafer 20 delimited by adjacent insulating structures 40.

In a second embodiment of the invention, the etching voltage V_{E} is varied continuously according to a linear ramp, as shown in Figure 21. Also in this case, the wafer voltage V_{W} is controlled so as to obtain the desired etching voltage V_{E}.

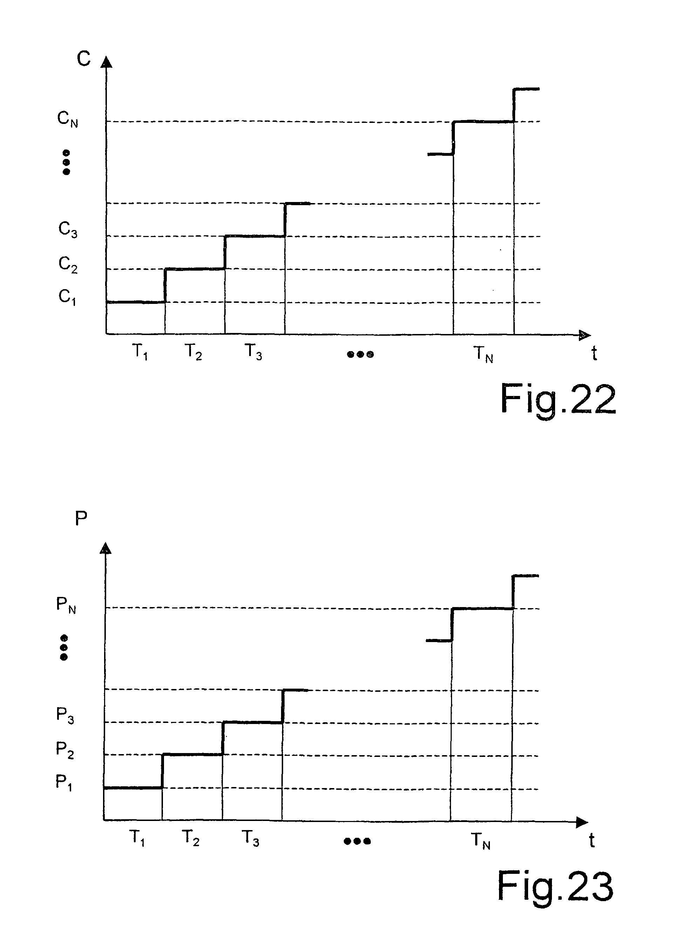

A third embodiment of the invention provides for varying the composition of the plasma used during the second polymerizing etch. In greater detail, at least two gases are present in the plasma: a first gas, for example HBr or Cl₂, is used for etching the substrate 21, while a second gas, for example O₂, HeO₂ or N₂, brings about polymerization and microdeposition of polymeric material. In order to control the polymerization rate, the concentration C of the polymerizing gas present in the mixture is varied. In particular, the concentration C is increased according to a discrete-ramp pattern, as illustrated in Figure 22.

In a fourth embodiment of the invention, during the second polymerizing etch the pressure P of the plasma is modified, also in this case according to a discrete-ramp pattern (see Figure 23).

The process described is advantageous mainly because it enables insulating structures to be made with inclined walls having a constant slope and at the same time provided with rounded top corners. It is therefore possible to exploit the advantages of the TCR technique also in the numerous cases where it is necessary to dig trenches with an oblique profile. In particular, it is possible to define active areas of high quality, to reduce the parasitic effects within the active areas. In addition, the use of the TCR technique for digging trenches reduces the risk of any crystallographic defects being generated in subsequent processing steps, especially during thermal treatment. In practice, then, both the yield of the process and the quality of the devices that can be made in the active areas improve considerably.

In addition, the process is carried out in an extremely simple way, in so far as the execution of a low number of steps is required, which are moreover very common in microelectronics. Consequently, also the overall cost of the process according to the invention is very contained.

Finally, it is evident that modifications and variations may be made to what is described herein, without departing from the scope of the present invention.

For example, during the second polymerizing etch, it is possible to vary the etching voltage in a way different from what has been described herein. In particular, the etching voltage may present a parabolic curve, either a continuous one or a discrete one, or even of some other type. Furthermore, in the case of an etching voltage that varies according to a staircase function, the increments of the etching voltage might not be uniform.

Likewise the various steps of the second polymerizing etch may also have different durations.

## Claims

1. A process for forming trenches with tapered profile and rounded top corners, comprising the steps of:
through a first polymerizing etch, forming in a substrate (21) of a semiconductor wafer (20) depressions (28) delimited by rounded top corners (29); and
through a second polymerizing etch, opening trenches (31) at said depressions (28);
**characterized in that** said second polymerizing etch is performed in variable plasma conditions and comprises varying said plasma conditions for controlling a polymerization rate and a slope (α) of walls (37) of said trenches (31) with respect to a face (38) of said substrate (21) such that said slope (α) of said walls (37) is kept constant.

2. The process according to claim 1, **characterized in that** said step of performing said second polymerizing etch comprises varying an etching voltage (V_{E}) between said plasma and said wafer (20).

3. The process according to claim 2, **characterized in that** said step of varying comprises increasing said etching voltage (V_{E}).

4. The process according to claim 2 or 3, **characterized in that** said etching voltage (V_{E}) is a discrete-ramp voltage.

5. The process according to claim 4, **characterized in that** said etching voltage (V_{E}) has steps of constant duration (T₁, T_{Z}, ..., T_{N}).

6. The process according to claim 5, **characterized in that** said constant duration (T₁, T₂, ..., T_{N}) is 30 s.

7. The process according to claim 2 or 3, **characterized in that** said etching voltage (V_{E}) is a linear-ramp voltage.

8. The process according to any one of claims 2 to 7, **characterized in that** said step of varying said etching voltage (V_{E}) comprises:
- placing said wafer (20) in an etching chamber (32);
- supplying to said etching chamber (32) a constant chamber voltage (V_{C}); and
- supplying to said wafer (20) a variable wafer voltage (V_{W})_{.}

9. The process according to any one of the preceding claims, **characterized in that** said second polymerizing etch is an HBr-and O₂-based etch.

10. The process according to claim 9, **characterized in that** said second polymerizing etch is made in the presence of Cl₂ and N₂.

11. The process according to any one of the preceding claims, **characterized in that** said first polymerizing etch is made using a substance chosen in the group comprising CHF₃, CH₂F₂.

12. The process according to any one of the preceding claims, **characterized in that** said step of performing said second polymerizing etch comprises increasing a concentration (C) of a polymerizing species present in said plasma.

13. The process according to any one of the preceding claims, **characterized in that** said step of performing said second polymerizing etch comprises increasing a pressure (P) of said plasma.

14. The process according to any one of the preceding claims, **characterized in that** said step of performing a first polymerizing etch and said step of performing a second polymerizing etch are performed using a masking structure (23, 26).

15. The process according to any one of the preceding claims, **characterized in that** it comprises the step of filling said trench (31) with a dielectric material.

## Patentansprüche

1. Verfahren zum Ausbilden von Gräben mit sich verjüngendem Profil und gerundeten Oberkanten, das die folgenden Schritte aufweist:
Ausbilden von durch gerundete Oberkanten (29) begrenzten Vertiefungen (28) in einem Substrat (21) aus einer Halbleiterscheibe (20) durch ein erstes Polymerisationsätzen;
Öffnen von Gräben (31) an den Vertiefungen (28) durch ein zweites Polymerisationsätzen;
**dadurch gekennzeichnet, daß** das zweite Polymerisationsätzen unter veränderlichen Plasmabedingungen durchgeführt wird und umfaßt, daß diese Plasmabedingungen verändert werden, um eine Polymerisationsgeschwindigkeit und eine Neigung (α) von Wänden (37) der Gräben (31) relativ zu einer Oberfläche (38) des Substrats (21) derart zu steuern, daß die Neigung (α) der Wände (37) konstant gehalten wird.

2. Verfahren nach Anspruch 1, **dadurch gekennzeichnet, daß** der Schritt des Durchführens des zweiten Polymerisationsätzens das Ändern einer Ätzspannung (V_{E}) zwischen dem Plasma und der Halbleiterscheibe (20) aufweist.

3. Verfahren nach Anspruch 2, **dadurch gekennzeichnet, daß** der Änderungsschritt das Erhöhen der Ätzspannung (V_{E}) aufweist.

4. Verfahren nach Anspruch 2 oder 3, **dadurch gekennzeichnet, daß** die Ätzspannung (V_{E}) eine in diskreten Schritten ansteigende Spannung ist.

5. Verfahren nach Anspruch 4, **dadurch gekennzeichnet, daß** die Ätzspannung (V_{E}) Stufen mit konstanter Dauer (T₁, T₂, ..., T_{N}) hat.

6. Verfahren nach Anspruch 5, **dadurch gekennzeichnet, daß** die konstante Dauer (T₁, T₂, ..., T_{N}) 30 s ist.

7. Verfahren nach Anspruch 2 oder 3, **dadurch gekennzeichnet, daß** die Ätzspannung (V_{E}) eine linear ansteigende Spannung ist.

8. Verfahren nach einem der Ansprüche 2 bis 7, **dadurch gekennzeichnet, daß** der Schritt des Änderns der Ätzspannung (V_{E}) aufweist:
- Anordnen der Halbleiterscheibe (20) in einer Ätzkammer (32);
- Anlegen einer konstanten Kammerspannung (V_{C}) an die Ätzkammer (32); und
- Anlegen einer veränderbaren Scheibenspannung (V_{W}) an die Halbleiterscheibe (20).

9. Verfahren nach einem der vorhergehenden Ansprüche, **dadurch gekennzeichnet, daß** das zweite Polymerisationsätzen ein Ätzen auf Basis von HBr und O₂ ist.

10. Verfahren nach Anspruch 9, **dadurch gekennzeichnet, daß** das zweite Polymerisationsätzen unter der Gegenwart von Cl₂ und N₂ durchgeführt wird.

11. Verfahren nach einem der vorhergehenden Ansprüche, **dadurch gekennzeichnet, daß** das erste Polymerisationsätzen unter Verwendung eines Stoffes durchgeführt wird, der aus der Gruppe ausgewählt wird, die aus CHF₃, CH₂F₂ besteht.

12. Verfahren nach einem der vorhergehenden Ansprüche, **dadurch gekennzeichnet, daß** der Schritt des Durchführens des zweiten Polymerisationsätzens das Erhöhen einer Konzentration (C) eines Polymerisationsstoffs in dem Plasma aufweist.

13. Verfahren nach einem der vorhergehenden Ansprüche, **dadurch gekennzeichnet, daß** der Schritt des Durchführens des zweiten Polymerisationsätzens das Erhöhen eines Drucks (P) des Plasmas aufweist.

14. Verfahren nach einem der vorhergehenden Ansprüche, **dadurch gekennzeichnet, daß** der Schritt des Durchführens eines ersten Polymerisationsätzens und der Schritt des Durchführens eines zweiten Polymerisationsätzens unter Verwendung einer Maskenstruktur (23, 26) durchgeführt werden.

15. Verfahren nach einem der vorhergehenden Ansprüche, **dadurch gekennzeichnet, daß** es den Schritt des Füllens des Grabens mit einem dielektrischen Material aufweist.

## Revendications

1. Procédé pour former des tranchées avec un profil en pointe et des coins supérieurs arrondis, comprenant les étapes consistant à :
former, au moyen d'un premier décapage de polymérisation, des creux (28) délimités
par des coins supérieurs arrondis (29) dans un substrat (21) d'une plaquette semiconductrice (20) ; et
ouvrir des tranchées (31) au niveau desdits creux (28) au moyen d'un deuxième décapage de polymérisation ;
**caractérisé en ce que** ledit deuxième décapage de polymérisation est réalisé dans des conditions de plasma variables et comprend la modification desdites conditions de plasma afin de commander un taux de polymérisation et une pente (α) des parois (37) desdites tranchées (31) par rapport à une face (38) dudit substrat (21) de telle sorte que ladite pente (α) desdites parois (37) est maintenue constante.

2. Procédé selon la revendication 1, **caractérisé en ce que** ladite étape consistant à réaliser ledit deuxième décapage de polymérisation comprend la modification de la tension de décapage (V_{E}) entre ledit plasma et ladite plaquette (20).

3. Procédé selon la revendication 2, **caractérisé en ce que** ladite étape consistant en la modification comprend l'augmentation de ladite tension de décapage (V_{E}).

4. Procédé selon la revendication 2 ou 3, **caractérisé en ce que** ladite tension de décapage (V_{E}) est une tension de rampe discrète.

5. Procédé selon la revendication 4, **caractérisé en ce que** ladite tension de décapage (V_{E}) comporte des étapes de durée constante (T₁, T₂, ..., T_{N}).

6. Procédé selon la revendication 5, **caractérisé en ce que** ladite durée constante (T₁, T₂, .... T_{N}) est de 30 s.

7. Procédé selon la revendication 2 ou 3, **caractérisé en ce que** ladite tension de décapage (V_{E}) est une tension de rampe linéaire.

8. Procédé selon l'une quelconque des revendications 2 à 7, **caractérisé en ce que** ladite étape consistant en la modification de ladite tension de décapage (V_{E}) comprend :
le placement de ladite plaquette (20) dans une chambre de décapage (32);
la fourniture à ladite chambre de décapage (32) d'une tension de chambre constante (Vc) ; et
la fourniture à ladite plaquette (20) d'une tension de plaquette variable (V_{W}).

9. Procédé selon l'une quelconque des revendications précédentes, **caractérisé en ce que** ledit deuxième décapage de polymérisation est un décapage à base de HBr- et O₂.

10. Procédé selon la revendication 9, **caractérisé en ce que** ledit deuxième décapage de polymérisation est effectué en présence de Cl₂ et de N₂.

11. Procédé selon l'une quelconque des revendications précédentes, **caractérisé en ce que** ledit premier décapage de polymérisation est effectué en utilisant une substance choisie dans le groupe comprenant CHF₃, CH₂F₂.

12. Procédé selon l'une quelconque des revendications précédentes, **caractérisé en ce que** ladite étape consistant à réaliser ledit deuxième décapage de polymérisation comprend l'augmentation d'une concentration (C) d'une espèce polymérisante présente dans ledit plasma.

13. Procédé selon l'une quelconque des revendications précédentes, **caractérisé en ce que** ladite étape consistant à réaliser ledit deuxième décapage de polymérisation comprend l'augmentation d'une pression (P) dudit plasma.

14. Procédé selon l'une quelconque des revendications précédentes, **caractérisé en ce que** ladite étape consistant à réaliser un premier décapage de polymérisation et ladite étape consistant à réaliser un deuxième décapage de polymérisation sont réalisées en utilisant une structure de masque (23, 26).

15. Procédé selon l'une quelconque des revendications précédentes, **caractérisé en ce qu'**il comprend l'étape consistant à remplir d'un matériau diélectrique ladite tranchée (31).
